# EUROPEAN PATENT APPLICATION

(11) **EP 4 776 314 A1**
(43) Date of publication of application: **15.07.2026**
(21) Application number: 25161262.8
(22) Date of filing: 03.03.2025
(51) Int. Cl.: H01G 4/255, H01G 4/005, H01G 4/33, H01G 4/38, H01L 23/525, H01L 23/522

(54) **TRIMMABLE CAPACITOR AND METHOD FOR TRIMMING TRIMMABLE CAPACITOR**

(30) Priority: 14.01.2025 US 202519019476
(71) Applicant: Winbond Electronics Corp., Taichung City, Taiwan. (TW)
(72) Inventor: PARK, San-Ha, Taichung City (TW)
(74) Representative: Becker, Eberhard

(57) **Abstract**

A trimmable capacitor structure and its trimming method are provided. The trimmable capacitor structure (10/10A) includes plural unit capacitors. At least one of the unit capacitors is a trimmable unit capacitor (100), including a first electrode plate (102) and a second electrode plate (104); a dielectric layer (106) provided between the first electrode plate (102) and the second electrode plate (104); a first metal line (110), provided to surround the first electrode plate (102); and a plurality of first trimming members (120), provided in a manner to electrically connect the first electrode plate (102) and the first metal line (110). The first metal line (110) is coupled to a first voltage (V1) and the second electrode plate (104) is coupled to a second voltage (V2).

## Description

### BACKGROUND

### Technical Field

The disclosure relates to a trimming scheme for a capacitor, and particularly to a trimmable capacitor and a method for trimming a trimmable capacitor.

### Description of Related Art

The silicon capacitance has process deviation. Due to the manufacturing process deviation, there may exist a deviation of -15% ~ +15%. For example, if a customer's requirement is +/-5%, a large amount of yield loss will happen. For this case, the silicon capacitor will have some yield loss, because some of deviation over limitation of specification.

According to customer's demand, there exists different requirements for capacitances of the silicon capacitors. If it has to provide the different mask set to make different capacitor to meet different capacitance requirements, the cost is increased, especially the shipping capability is small.

Therefore, there requires to develop a scheme to make the capacitor with the same mask set.

### SUMMARY

In view of the description, according to one embodiment of the disclosure, a trimmable capacitor is provided. The trimmable capacitor comprises a plurality of unit capacitors, where at least one of the plurality of unit capacitors is a trimmable unit capacitor. The trimmable unit capacitor comprises a first electrode plate and a second electrode plate; a dielectric layer provided between the first electrode plate and the second electrode plate; a first metal line, provided to surround the first electrode plate; and a plurality of first trimming members, provided in a manner to electrically connect the first electrode plate and the first metal line. The first metal line is coupled to a first voltage and the second electrode plate is coupled to a second voltage.

According to one embodiment of the disclosure, a method for trimming a trimmable capacitor, comprising: providing a plurality of unit capacitors that forms the trimmable capacitor, wherein at least one of the plurality of unit capacitors is a trimmable unit capacitor, and the trimmable unit capacitor comprises: a first electrode plate and a second electrode plate; a dielectric layer provided between the first electrode plate and the second electrode plate; providing a first metal line to surround the first electrode plate, wherein the first metal line is coupled to a first voltage and the second electrode plate is coupled to a second voltage; providing a plurality of first trimming members a manner to electrically connect the first electrode plate and the first metal line; and trimming off first trimming members when the trimmable unit capacitor has not to be functioned.

### BRIEF DESCRIPTION OF THE DRAWINGS

FIG. 1A and FIG. 1B illustrate an exemplary layout of a unit capacitor for a trimmable capacitor according to one embodiment of the present disclosure.
FIG. 2A and FIG. 2B illustrate other exemplary layouts of a trimmable unit capacitor for a trimmable capacitor according to another embodiment of the present disclosure.
FIG. 3A and FIG. 3B illustrate a capacitor structure according to embodiments of the present disclosure.
FIGs. 4A-4B to FIGs. 6A-6B illustrate equivalent circuits of a trimmable unit capacitor according to embodiments of the present disclosure.
FIGs. 7A-7B and FIGs. 8A-8B illustrate variation embodiment of a trimmable unit capacitor according to embodiments of the present disclosure.

### DESCRIPTION OF THE EMBODIMENTS

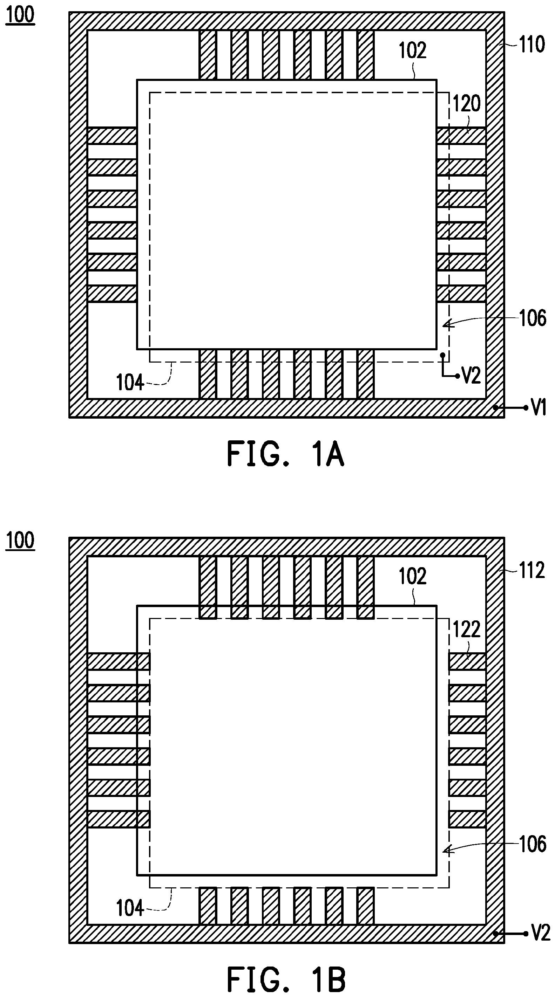

Referring to FIG. 1A and FIG. 1B, the capacitance of the trimmable capacitor can be trimmed based on the requirement by trimming one or more unit capacitors that form the trimmable capacitor.

In the embodiment, the trimmable capacitor may comprises a plurality of unit capacitors, and at least one of the plurality of unit capacitors is a trimmable unit capacitor 100 as shown in FIG. 1A. The trimmable unit capacitor 100 comprises a basic capacitor structure that includes a first electrode plate 102 and a second electrode plate 104. A dielectric layer 106 is provided between the first electrode plate 102 and the second electrode plate 104.

The trimmable unit capacitor 100 further comprises a first metal line 110, and the first metal line 110 is provided to surround the first electrode plate 102. In one embodiment, the trimmable unit capacitor 100 may be a polygonal shape with multiple sides (viewed from top or bottom), or other suitable shape. In FIG. 1A, trimmable unit capacitor 100 is a square shape with four sides. Namely, the first electrode plate 102 and the second electrode plate 104 are also square shape with four sides. Therefore, in one embodiment, the first metal line 110 may be provided with the same shape as the first electrode plate 102 and the second electrode plate 104. In addition, the first metal line 110 may have different shape from the first electrode plate 102 and the second electrode plate 104.

In addition, the first metal line 110 may be an enclosed shape, i.e., the first metal line 110 may completely surround the first electrode plate 102 and/or the second electrode plate 104. In one embodiment, the first metal line 110 may be formed in a metal layer with the same level as the first electrode plate 102 and/or the second electrode plate 104. In another embodiment, the first metal line 110 may be formed in a metal layer higher or lower than the first electrode plate 102 and/or the second electrode plate 104.

In FIG. 1A, the trimmable unit capacitor 100 may further comprise a plurality of first trimming members 120. The first trimming members 120 are provided in a manner to electrically connect the first electrode plate 102 and the first metal line 110. In one embodiment, the first trimming members 120 are provided at each side of the first electrode plate 102 to electrically connect to the first metal line 110. However, the first trimming members 120 may be provided at a portion of the sides of the first electrode plate 102. In addition, the number of the first trimming members 120 at each side of the first electrode plate 102 may be the same or different. Moreover, the interval between two adjacent first trimming members 120 may be the same or different (random). The layout or arrangement of the first trimming members 120 may be designed according to the requirement. In addition, the number of the first trimming member 120 in each side of the first electrode plate 102 may be determined according to the target ESR/ESL (Equivalent Series Resistance / Equivalent Series Inductance) and the layout situation.

In one embodiment, each of the first trimming members 120 may be a metal fuse (mechanical structure). Thus, the one end of the trimmable unit capacitor 100 is coupled to the first voltage V1 through the metal fuse, and the other end of the trimmable unit capacitor 100 is coupled to the second voltage V2. The connection between the first electrode plate 102 and the first metal line 110 can be disconnected by trimming off the first trimming members 120. Therefore, the trimmable unit capacitor 100 may be not functioned by trimming off the first trimming members 120.

In FIG. 1B, according to another embodiment, the trimmable unit capacitor 100 may further comprise a second metal line 112, and the second metal line 112 is also provided to surround the second electrode plate 104. Similarly, in the embodiment, the second metal line 112 may be also provided with the same shape as the first electrode plate 102 and the second electrode plate 104. In addition, the second metal line 112 may have different shape from the first electrode plate 102 and the second electrode plate 104. In addition, the shape of the second metal line 112 may have the same as or different from the shape of the first metal line 110.

In addition, the second metal line 112 may be an enclosed shape, i.e., the second metal line 112 may completely surround the first electrode plate 102 and/or the second electrode plate 104. In one embodiment, the second metal line 112 may be formed in a metal layer with the same level as the first electrode plate 102 and/or the second electrode plate 104. In another embodiment, the second metal line 112 may be formed in a metal layer higher or lower than the first electrode plate 102 and/or the second electrode plate 104.

In FIG. 1B, the trimmable unit capacitor 100 may further comprise a plurality of second trimming members 122. The second trimming members 122 are provided in a manner to electrically connect the second electrode plate 104 and the second metal line 112. In one embodiment, the second trimming members 122 are provided at each side of the second electrode plate 104 to electrically connect to the second metal line 112. However, the second trimming members 122 may be provided at a portion of the sides of the second electrode plate 104. In addition, the number of the second trimming members 122 at each side of the second electrode plate 104 may be the same or different. Moreover, the interval between two adjacent second trimming members 122 may be the same or different (random). The layout or arrangement of the second trimming members 122 may be designed according to the requirements. In addition, the number of the second trimming member 122 in each side of the second electrode plate 104 may be determined according to the target ESR/ESL (Equivalent Series Resistance / Equivalent Series Inductance) and the layout situation.

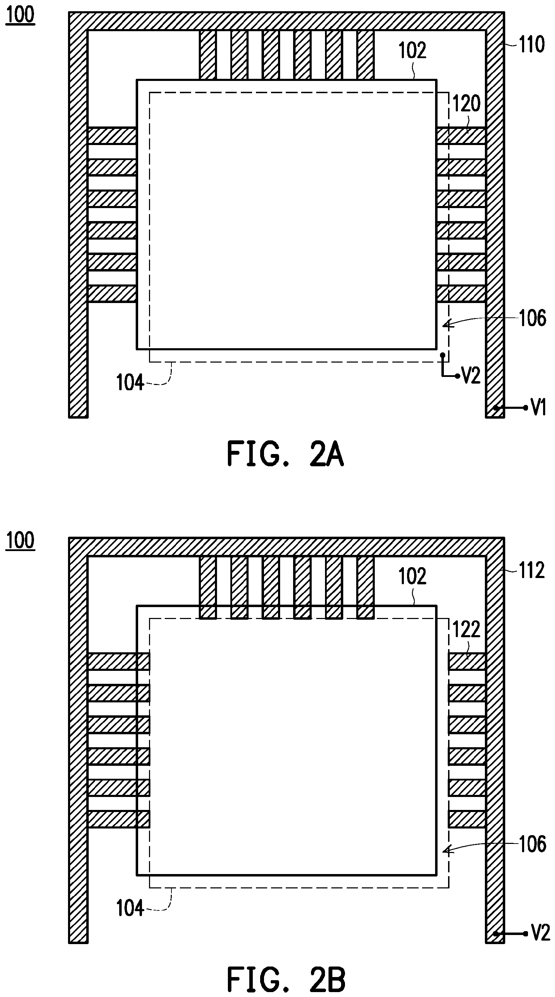

In FIGs. 1A/1B and FIGs. 2A/2B, the second metal line 112 is coupled to a second voltage V2. Therefore, two ends of the trimmable unit capacitor 100 are respectively applied with the first voltage V1 and the second voltage V2.

In one embodiment, each of the second trimming members 122 may be a metal fuse (mechanical structure). Thus, two ends of the trimmable unit capacitor 100 are respectively coupled to the first voltage V1 and the second voltage V2 through the metal fuses (first and second trimming members 120, 122). The connection between the first electrode plate 102 and the first metal line 110 can be disconnected by trimming off the first trimming members 120, and the connection between the second electrode plate 104 and the second metal line 112 can be disconnected by trimming off the second trimming members 122. Therefore, the trimmable unit capacitor 100 may be not functioned by trimming off both of the first trimming members 120 and the second trimming members 122, or one of the first trimming members 120 and the second trimming members 122.

In FIG. 2A and FIG. 2B, variation examples of the trimmable unit capacitor 100 are illustrated. As shown, instead of the enclosed first metal line 110 and the second metal line 112 illustrated in FIG. 1A and 1B, the first metal line 110 and the second metal line 112 can be formed in an opened shape (not completely enclosed). In FIG. 2A and 2B, the first metal line 110 and the second metal line 112 surround three sides of the first electrode plate 102 and the second electrode plate, but the degree of the opened range may be made based on the layout requirements, no particular limitation is required.

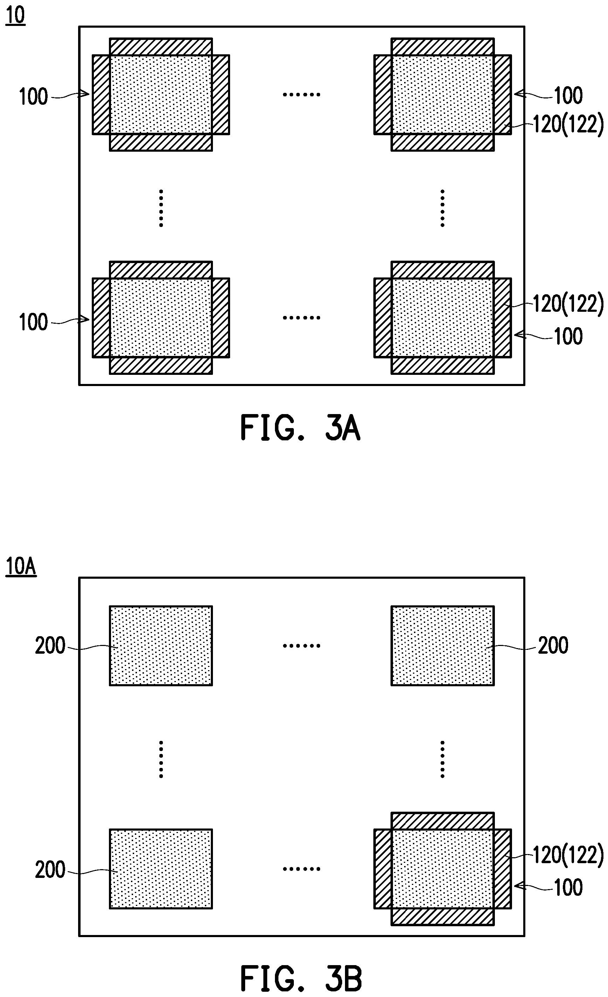

FIGs. 3A and 3B illustrate layout examples of a trimmable capacitor according to embodiments of the present disclosure. In FIG. 3A, the trimmable capacitor 10 may be provided a plurality of unit capacitors, and all unit capacitors are trimmable unit capacitor 100 with the first trimming members 120 and/or the second trimming members 122 as illustrated in FIGs. 1A-1B or FIGs. 2A-2B. In FIG. 3B, the trimmable capacitor 10A may be provided a trimmable unit capacitor 100 with the first trimming members 120 and/or the second trimming members 122 as illustrated in FIGs. 1A-1B or FIGs. 2A-2B and a plurality of unit capacitors 200 without trimming members. For simplicity, the first metal line 110 and/or the second metal line 112 are omitted. Therefore, according to the embodiment of the disclosure, the trimmable capacitor 10 (or 10A) are provided with a least one trimmable unit capacitor. Among all unit capacitor, the number of the trimmable unit capacitors 100 can be determined based on the requirements.

Therefore, when the trimmable capacitor 10 or 10A is used, a portion of the trimmable unit capacitor in the trimmable capacitor 10 may be trimmed off to meet the required capacitance of a specified specification. There is not necessary to provide different mask set to make different capacitors for different specifications.

In addition, according to the trim range of the capacitance of the trimmable capacitor 10 (10A), a portion of the unit capacitors may be the trimmable unit capacitor, such as 10%, 20%, 50% or even 100% of the unit capacitors are the trimmable unit capacitor 100.

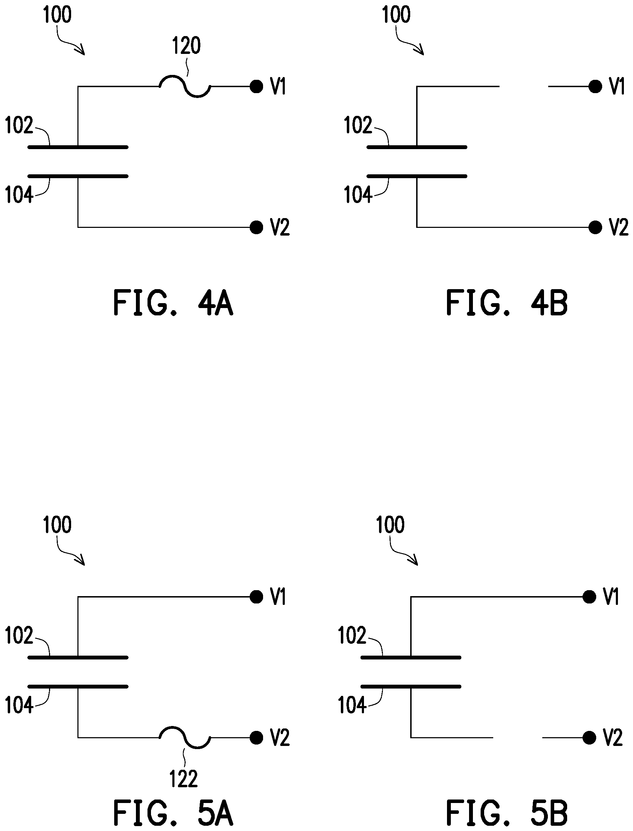

FIGs. 4A-4B to 6A-6B illustrate equivalent circuits of a trimmable unit capacitor according to embodiments of the present disclosure. In FIG. 4A and FIG. 4B, the trimmable unit capacitor 100 has the metal fuse 120 for connecting the first electrode plate 102 to the first voltage V1 through first trimming members (forming the metal fuse) 120, and the second electrode plate 104 is coupled to the second voltage V2. The metal fuse 120 is provided at the side of the first voltage V1. In addition, for simplicity, one metal fuse 120 is depicted, but more metal fuses (first trimming members 120) may be used. In FIG. 4B, when the trimmable unit capacitor 100 is not necessary to be functioned, the metal fuse 120 may be trimmed off (blown or physically cut off by any suitable means). As a result, one end (the first voltage V1 side) of the trimmable unit capacitor 100 is opened and thus the trimmable unit capacitor 100 is trimmed off.

In FIG. 5A and FIG. 5B, the trimmable unit capacitor 100 has the metal fuse 122 for connecting the second electrode plate 104 to the second voltage V2 through second trimming members (forming the metal fuse) 122, and the first electrode plate 102 is coupled to the first voltage V1. The metal fuse 122 is provided at the side of the second voltage V2. In addition, for simplicity, one metal fuse 122 is depicted, but more metal fuses (second trimming members 122) may be used. In FIG. 5B, when the trimmable unit capacitor 100 is not necessary to be functioned, the metal fuse 122 may be trimmed off (blown or physically cut off by any suitable means). As a result, one end (the second voltage V2 side) of the trimmable unit capacitor 100 is opened and thus the trimmable unit capacitor 100 is trimmed off.

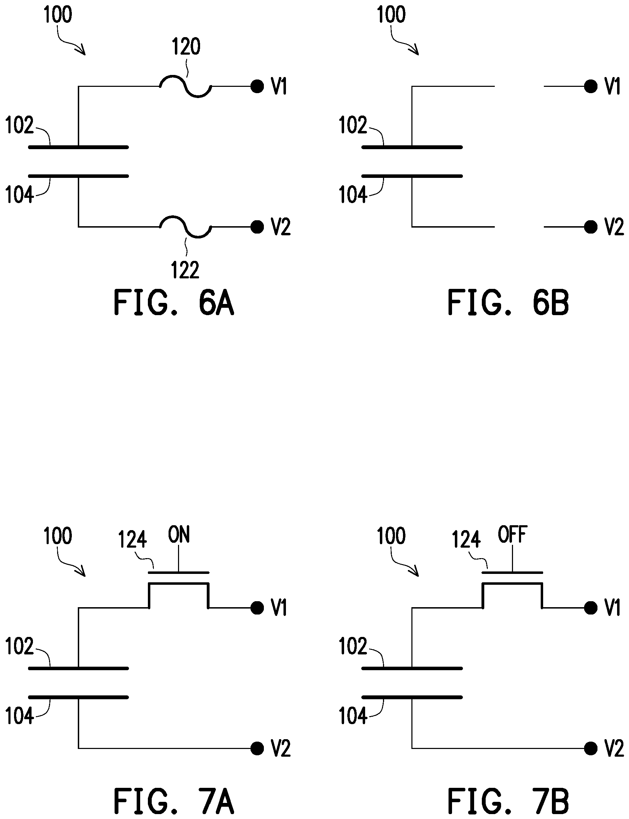

In FIG. 6A and FIG. 6B, the trimmable unit capacitor 100 has the metal fuse 120 for connecting the first electrode plate 102 to the first voltage V1 through first trimming members (forming the metal fuse) 120 and the metal fuse 122 for connecting the second electrode plate 104 to the second voltage V2 through second trimming members (forming the metal fuse) 122. The metal fuse 120 is provided at the side of the first voltage V1 and the metal fuse 122 is provided at the side of the second voltage V2. Similarly, one metal fuse 120 and one metal fuse 122 are depicted, but more metal fuses 120, 122 (first and second trimming members 120, 122) may be used. In FIG. 6B, when the trimmable unit capacitor 100 is not necessary to be functioned, the metal fuses 120, 122 may be trimmed off (blown or physically cut off by any suitable means). As a result, two ends of the trimmable unit capacitor 100 are opened and thus the trimmable unit capacitor 100 is trimmed off. Alternatively, the trimmable unit capacitor 100 may be trimmed off by blowing the metal fuse 120 or the metal fuse 122.

In FIGs. 7A and 7B, instead of the metal fuse, the first trimming members 120 and the second trimming members 122 may be respectively implemented by switching elements. The switching elements may be implemented by transistors such as MOS transistors, MOSFET transistor or other suitable transistors. In FIGs. 7A and 7B, the transistor 124 is provided at the side of the first voltage V1, i.e., the first electrode plate 102 is coupled to the first voltage V1 through the transistor (first trimming member) 124 and the second electrode plate 104 is coupled to the second voltage V2.

When the transistor 124 is turned on, the first electrode plate 102 is electrically connected to first metal line 110, i.e., coupled to the first voltage V1. In addition, one transistor 124 is depicted, but more transistors (first trimming members) 124 may be used. When the transistor 124 is turned off, the first electrode plate 102 is disconnected from the first voltage V1. As a result, one end (the first voltage V1 side) of the trimmable unit capacitor 100 is opened and thus the trimmable unit capacitor 100 is trimmed off.

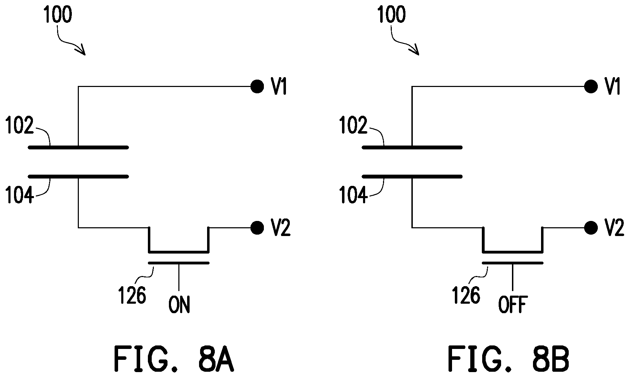

Alternatively, in FIGs. 8A and 8B, the transistor 126 is provided at the side of the second voltage V2, i.e., the second electrode plate 104 is coupled to the second voltage V2 through the transistor (second trimming member) 126 and the first electrode plate 102 is coupled to the first voltage V1. In addition, one transistor 126 is depicted, but more transistors (second trimming members) 126 may be used.

When the transistor 126 is turned on, the second electrode plate 104 is electrically connected to second metal line 112, i.e., coupled to the second voltage V2. When the transistor 126 is turned off, the second electrode plate 104 is disconnected from the second voltage V2. As a result, one end (the second voltage V2 side) of the trimmable unit capacitor 100 is opened and thus the trimmable unit capacitor 100 is trimmed off. Similarly, the transistors 124, 126 may be provided at both sides of the first voltage V1 and the second voltage V2.

In addition, the transistor 124 and the transistor 126 may be controlled to turn on or off by a fuse option. The fuse option may be implemented by a metal fuse or an electrical fuse.

In summary, the trimmable capacitor of the disclosure comprises a plurality of unit capacitors, and a portion of the unit capacitors may be implemented by the aforementioned various trimmable unit capacitors. Therefore, one trimmable capacitor may meet various capacitance requirements by trimming off trimmable unit capacitors. The trimmable capacitor of the disclosure may support to meet the target specification for the specified capacitance amount without yield loss. In addition, the trimmable capacitor of the disclosure may support various capacitance amounts of a silicon capacitor product using the same mask set.

## Claims

1. A trimmable capacitor (10/10A), comprising:
a plurality of unit capacitors, at least one of the plurality of unit capacitors being a trimmable unit capacitor (100),
wherein the trimmable unit capacitor (100) comprises:
a first electrode plate (102) and a second electrode plate (104);
a dielectric layer (106) provided between the first electrode plate (102) and the second electrode plate (104);
a first metal line (110), provided to surround the first electrode plate (102); and
a plurality of first trimming members (120), provided in a manner to electrically connect the first electrode plate (102) and the first metal line (110),
wherein the first metal line (110) is coupled to a first voltage (V1) and the second electrode plate (104) is coupled to a second voltage (V2).

2. The trimmable capacitor according to claim 1, wherein the first metal line (110) is an enclosed shape.

3. The trimmable capacitor according to claim 1, wherein intervals between two adjacent first trimming members (120) are random or the same.

4. The trimmable capacitor according to claim 1, wherein the trimmable unit capacitor (100) further comprises:
a second metal line (112), provided to surround the second electrode plate (104) and coupled to the second voltage (V2); and
a plurality of second trimming members (122), provided in a manner to electrically connect the second electrode plate (104) and the second metal line (112).

5. The trimmable capacitor according to claim 4, wherein intervals between two adjacent second trimming members (122) are random or the same.

6. The trimmable capacitor according to claim 4, wherein the second metal line (112) is an enclosed shape.

7. The trimmable capacitor according to claim 1, wherein each of the first trimming members (120) is a metal fuse.

8. The trimmable capacitor according to claim 1, wherein each of the first trimming members (120) is a switching element.

9. The trimmable capacitor according to claim 4, wherein the switching element is a transistor (124).

10. The trimmable capacitor according to claim 9, wherein the transistor (124) is controlled to turn on or off by a metal fuse or an electrical fuse.

11. The trimmable capacitor according to claim 4, wherein each of the second trimming members (122) is a metal fuse.

12. The trimmable capacitor according to claim 4, wherein each of the second trimming members (122) is a switching element.

13. The trimmable capacitor according to claim 12, wherein the switching element is a transistor (126).

14. The trimmable capacitor according to claim 12, wherein the transistor (126) is controlled to turn on or off by a metal fuse or an electrical fuse.

15. A method for trimming a trimmable capacitor, comprising:
providing a plurality of unit capacitors that forms the trimmable capacitor (10/10A), wherein at least one of the plurality of unit capacitors is a trimmable unit capacitor (100), and the trimmable unit capacitor (100) comprises: a first electrode plate (102) and a second electrode plate (104); a dielectric layer (106) provided between the first electrode plate (102) and the second electrode plate (104);
providing a first metal line (110) to surround the first electrode plate (102), wherein the first metal line (110) is coupled to a first voltage (V1) and the second electrode plate (104) is coupled to a second voltage (V2);
providing a plurality of first trimming members (120) in a manner to electrically connect the first electrode plate (102) and the first metal line (110); and
trimming off the first trimming members (120) when the trimmable unit capacitor (100) has not to be functioned.

16. The method according to claim 15, further comprising:
providing a second metal line (112) to surround the second electrode plate (104) and coupled to the second voltage (V2); and
providing a plurality of second trimming members (122) in a manner to electrically connect the second electrode plate (104) and the second metal line (112).
